# EUROPÄISCHE PATENTANMELDUNG

(11) **EP 0 638 924 A1**
(43) Veröffentlichungstag der Anmeldung: **15.02.1995**
(21) Anmeldenummer: 94111924.0
(22) Anmeldetag: 30.07.1994
(51) Int. Cl.: H01L 21/48, H05K 3/00

(54) **Verfahren zum Herstellen von TAB-Filmträgern**

(30) Priorität: 06.08.1993 DE 4326424
(71) Anmelder: ROBERT BOSCH GMBH, 70442 Stuttgart (DE)
(72) Erfinder: Seeger, Klaus, D-71522 Backnang (DE)

(57) **Zusammenfassung**

Es wird vorgeschlagen bei der Herstellung von Filmträgern für die tape automated bonding(TAB)-Technik eine Kupferschicht (2) mit Fensterbereichen (4) zu strukturieren. Zur Bearbeitung der Kunststoffolie (1), die ebenfalls Fensterbereiche aufweisen muß, wird die strukturierte Kupferschicht (2) als Maske eingesetzt. Die Kunststoffolie (1) wird mittels Laserbearbeitung an den nicht mit der Kupferschicht (2) bedeckten Fensterbereichen (4) entfernt. Als Laser ist es sinnvoll einen Excimerlaser einzusetzen.

## Beschreibung

Die Erfindung betrifft ein Verfahren zum Herstellen von TAB-Filmträgern nach dem Oberbegriff des Patentanspruches 1 und des Patentanspruches 2.

Aus der DE 39 19 249 A1 ist ein verfahren zum Herstellen von TAB (tape automated bonding)-Filmträgern in Zweilagentechnik bekannt. Das Verfahren ist dabei so ausgestaltet, daß keine umweltschädlichen Lösungsmitteln verwendet werden müssen. Das Verfahren umfaßt folgende Schritte: eine beidseitig mit einer dünnen Kupferschicht versehene Kunststoffolie wird auf beiden Seiten mit einem Fotoresist beschichtet. Der Fotoresist wird durch Fotodruck und Entwicklung auf der einen Seite ganzflächig und auf der anderen Seite unter Freilegung von Fensterbereichen gehärtet. In den freigelegten Fensterbereichen der anderen Seite wird die Kupferschicht weggeätzt. Auf beiden Seiten wird der Fotoresist gestrippt. Auf beiden Seiten wird ein weiterer Fotoresist aufgebracht. Der Fotoresist wird durch Fotodruck und Entwicklung auf der einen Seite unter Freilegen einer Leiterstruktur und auf der anderen Seite ganzflächig gehärtet. In den freigelegten Bereichen der einen Seite wird eine der Leiterbahndicke entsprechende Kupferschicht galvanisch aufgebaut. Auf beiden Seiten wird der Fotoresist gestrippt. Die Kunststoffolie an den nicht mit einer Kunststoffschicht bedeckten Fensterbereichen der anderen Seite wird weggeätzt. Die die Kunststoffolie beidseitig in den freiliegenden Bereichen noch umgehende dünne Kupferschicht wird durch Differenzätzen entfernt. Beim Wegätzen der Fensterbereiche dient die dünne Kupferschicht als Ätzresistschicht. Dieses Verfahren weist den Nachteil auf, daß das Wegätzen der Kunststoffolie nicht mit einer hohen Genauigkeit erfolgen kann. Die Ränder der so erzeugten Fenster in der Kunststoffolie sind keinesfalls geradwandig und genau, sondern es erfolgt eine Unterätzung.

Aus der DE 41 34 172 A1 ist eine Mehrschichtverbindungsvorrichtung und ein Verfahren zu ihrer Herstellung bekannt. Die Verbindungsvorrichtung ist für elektronische Bauelemente, wie integrierte Schaltungen , Multichip-Module u. ä. geeignet. Die Verbindungsvorrichtung besteht aus einer Vielzahl von schichten mit Trennschichten, Signal- und Spannungsebenen. Um Verbindungsdurchgänge zwischen den Schichten zu definieren wird eine Laserbohrung verwendet. Die Verfahren zur Herstellung der Mehrschichtverbindungsvorrichtungen sind sehr aufwendig.

Es ist Aufgabe der Erfindung ein Verfahren zum Herstellen von TAB-Filmträgern anzugeben, das für den Einsatz für kleinste bis mittlere Stückzahen geeignet ist.

Die Aufgabe wird gelöst durch Verfahren mit Merkmalen der Patentansprüche 1 bzw. 2. Vorteilhafte Weiterbildungen sind in den Unteransprüchen angegeben.

Der Einsatz der TAB-Technik, d. h. des automatischen Bondens mit Bändern wird für kleinste bis mittlere Stückzahlen nur dann wirtschaftlich, wenn es nicht mehr notwendig ist, die Kunststoffolien mittels extrem teurer Stanzwerkzeuge herzustellen. Aus der DE 39 19 249 A1 ist es nun bereits bekannt die Kunststoffolien naßchemisch zu ätzen. Eine solche Ätzung weist jedoch leider keine hohe Genauigkeit auf. Im Gegensatz dazu sind die Aussparungen in der Kunststoffolie durch Laserbearbeitung sehr genau. Zudem macht die Laserbearbeitung einen Mehrlagenaufbau möglich. Eine Herstellung von Kontaktnasen ("bumped" TAB-Strukturen) wird durch den Einsatz der Laserbearbeitung sowohl bei einseitigen TAB-Strukturen als auch TAB-Strukturen in Mehrlagenaufbautechnik ermöglicht.

Anhand der Figuren werden nun Ausführungsbeispiele der Erfindung beschrieben. Es zeigen:
Figur 1 Vorder- und Rückseite für einen einseitigen TAB-Film-Träger,
Figur 2 einen Schnitt durch einen TAB-Filmträger nach Laserbearbeitung,
Figur 3 einer Ansicht eines TAB-Filmträger nach Laserbearbeitung,
Figur 4 einen vergrößerten Ausschnitt aus der Ansicht gemäß Figur 3,
Figur 5a bis g je einen Schnitt durch einen Filmträger in verschiedenen Verfahrensstadien zur Herstellung einer Kontaktnase,
Figur 6 Kontaktierung eines ICs in bumped TAB-Technik und
Figur 7 ein Schnitt durch einen TAB-Filmträger mit einer seitlich isolierten Kontaktnase.

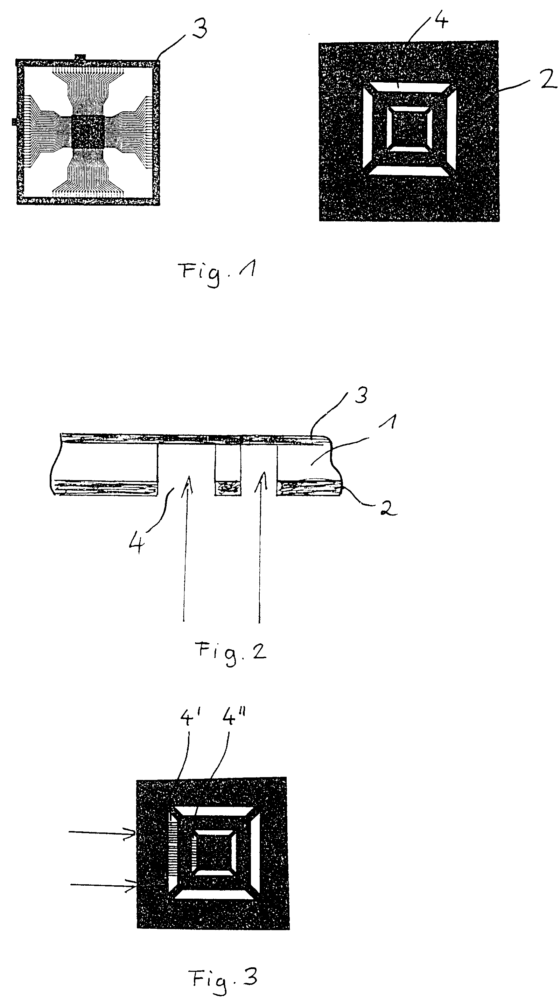

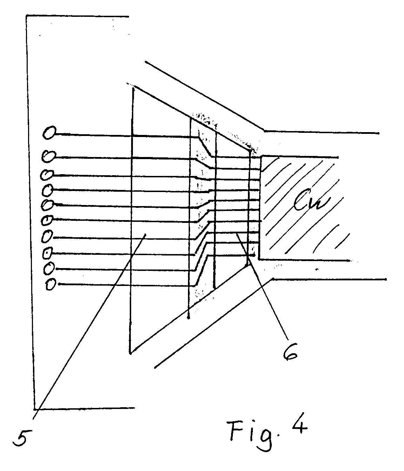

Zur Herstellung eines TAB-Filmträgers wird von einer Kunststoffolie 1 ausgegangen, die beidseitig mit einer Kupferschicht 3 versehen ist. Auf der einen Seite der Kunststoffolie 1 werden Fensterbereiche 4 aus der Kupferschicht 3 entfernt. Dies ist in Figur 1 auf der rechten Seite dargestellt. Auf der anderen Seite wird die Kupferschicht 3 in Form eines Leiterbildes strukturiert. Ein solches Leiterbild mit Verbindungsleitungen ist auf der linken Seite von Figur 1 dargestellt. Figur 2 zeigt nun einen Schnitt durch eine solche Kunststoffolie 1 mit Kupferschichten, wobei die Kunststoffolie 1 in den Fensterbereichen 4 bereits mittels eines Lasers entfernt wurde. Die Pfeile in Figur 2 deuten die Laserbearbeitung an. Figur 3 zeigt nun eine erfindungsgemäße Struktur wenn die Kunststoffolie in den Fensterbereichen 4' und 4'' bereits entfernt wurde. Eine Vergrößerung dieser Struktur ist in Figur 4 dargestellt. Dabei werden mit 5 und 6 die Bereiche des outer lead bzw. inner lead bonds dargestellt.

Soll ein TAB-Filmträger in Mehrlagentechnik hergestellt werden, so wird ein flexibles Multilayer eingesetzt, daß eine oder mehrere Innenlagen aus Kupfer mit Leiterbildern aufweist und Zwischenlagen aus Kunststoffolie. Die Struktur die in Figur 1 auf der linken Seite dargestellt ist, befindet sich dann im Innern des Multilayers. Die auf der rechten Seite von Figur 1 abgebildete Kupferstruktur ist dann auf beiden Seiten des Multilayeres vorzusehen. Eine Laserbearbeitung des Multilayers muß ebenfalls von beiden Seiten durchgeführt werden. Als Basismaterialien für die TAB-Strukturen kommen beispielsweise flexible Kunststoffe, wie Polyester oder Polyamid zum Einsatz. Eine Voraussetzung ist, daß der entsprechende Kunststoff laserätzbar ist. Nach der Strukturierung der Kupferschichten durch standardmäßige Leiterplattentechnik wird die Kunststoffschicht durch eine Laserbearbeitung im Bereich des inner-lead und des outer-lead-bonds entfernt. Dabei dient die mit Fensterbereichen strukturierte Kupferschicht als Maske. Anschließend kann die Strukturseite und eventuell auch die Rückseite mit einer für Verbindungsprozesse geeigneten Oberfläche, z. B. aus Gold oder Zinn, versehen werden. Die für die Laserstrukturierung benötigte Kupferrückseite kann in diesem Stadium auch durch einen Ätzvorgang entfernt werden. Die weitere Bearbeitung bis zur Kontaktierung des gehäusten Halbleiters erfolgt dann in für TAB-Technik üblichen Verfahrensweisen. Beide Arten von TAB-Filmträgern, sowohl für einseitige TAB-Filmträger als auch für Filmträger in Mehrlagentechnik können auch mit einer Kontaktnase ("bumped-TAB-Technik") hergestellt werden. Die Anwendung des erfindungsgemäßen Verfahrens mit Laserbearbeitung zur Herstellung von TAB-Filmträger mit Konktaktnasen wird nun beschrieben.

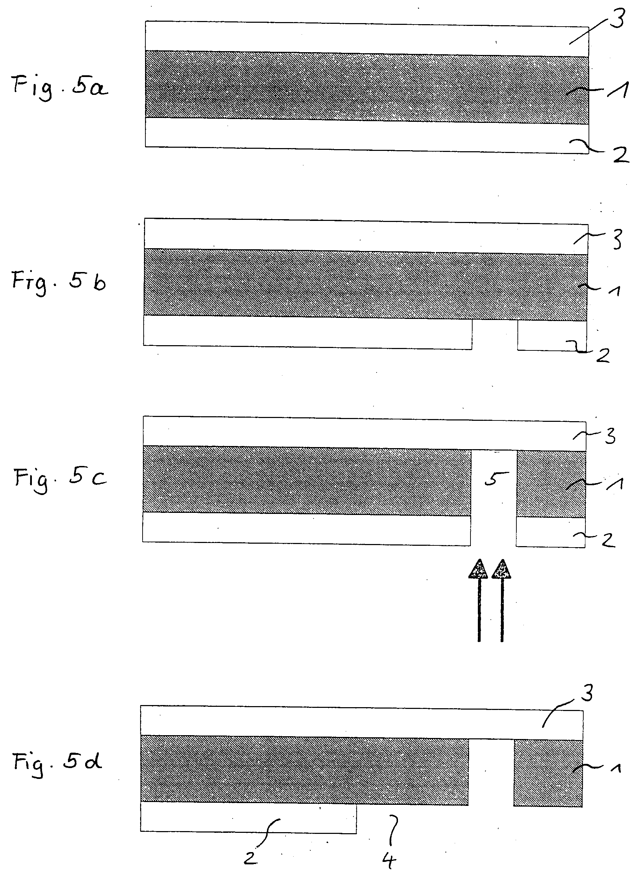

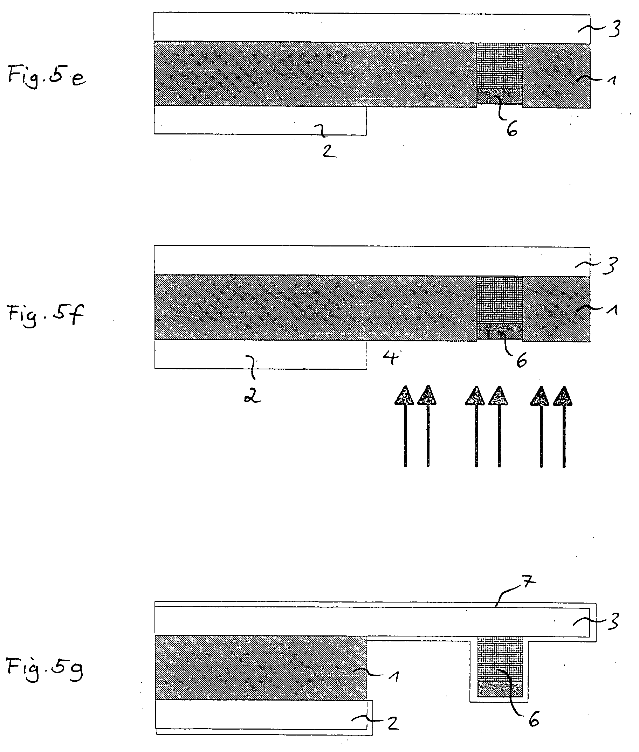

Ausgangsmaterial ist beispielsweise eine Kunststoffolie die auf beiden Seiten mit Kupfer beschichtet ist. Die Herstellung in Mehrlagentechnik erfolgt analog, wobei die in den Figuren 5 und 6 obere Lage aus Kupfer dann eine Innenlage des Multilayers wäre. Diese Kupferschicht 3 wird also in Form eines Leiterbildes strukturiert und stellt die Verbindungsebene da. Sie ist durch die Kunststoffolie 1 von einer zweiten Kupferschicht 2 getrennt. Die Kupferschicht 2 wird zur Herstellung von Kontaktnasen bereichsweise entfernt. Mittels Laserbearbeitung, die in Figur 5c durch Pfeile angedeutet ist, wird dann die Kunststoffolie 1 ebenfalls bereichsweise entfernt. Aus der strukturierten Kupferschicht 2 werden dann Fensterbereiche entfernt. In der entstandenen Aussparung 5 der Kunststoffolie 1 wird eine Kontaktnase 6 galvanisch aufgebaut. Die Kunststoffolie 1 wird mittels Laserbearbeitung (in Figur 5f durch Pfeile angedeutet) in den Fensterbereichen 4 entfernt. Es entsteht eine frei hervorstehende Kontaktnase, die an einer Leiterbahn der Kupferschicht 3 befestigt ist. Es erweist sich zur besseren Kontaktierung als sinnvoll die Kupferoberfläche nach Abschluß der Laserbearbeitung galvanisch mit Gold 7 zu beschichten. Die Laserbearbeitung kann besonders günstig mit einem Excimerlaser durchgeführt werden. In Figur 6 ist nun dargestellt, wie ein Halbleiter 8 mit seinem Kontaktpad 9 an einer Kontaktnase befestigt werden kann.

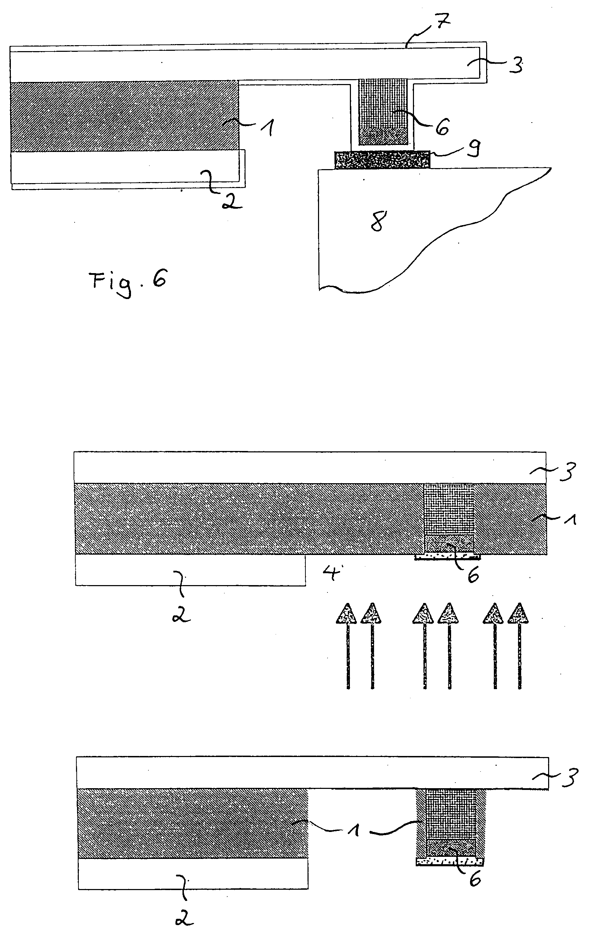

Falls eine seitliche Isolation der Kontaktnase gewünscht wird, so ist es möglich, die Kontaktnase galvanisch über die Kunststoffolie 1 hinaus aufzubauen. Dadurch erfolgt eine Abschattung bei der Laserbearbeitung, so daß ein Teil der Kunststoffolie 1 links und rechts von der Kontaktnase stehen bleibt. Eine solche vorteilhafte Ausführungsform ist in Figur 7 dargestellt.

## Patentansprüche

1. Verfahren zum Herstellen von TAB-Filmträgern für einseitige TAB-Filmträger, wobei eine beidseitig mit einer Kupferschicht (2,3) versehene Kunststoffolie (1) eingesetzt wird, auf der einen Seite der Kunststoffolie (1) Fensterbereiche (4) aus der Kupferschicht (2) entfernt werden und auf der anderen Seite die Kupferschicht (3) in Form eines Leiterbildes strukturiert wird, dadurch gekennzeichnet, daß eine laserätzbare Kunststoffolie (1) eingesetzt wird,
daß die Kunststoffolie (1) an den nicht mit der Kupferschicht (2) bedeckten Fensterbereichen (4) mittels Laserbearbeitung von der einen Seite aus entfernt wird wobei die Kupferschicht (2) der einen Seite als Maske dient.

2. Verfahren zum Herstellen von TAB-Filmträgern in Mehrlagentechnik, wobei ein flexibles Multilayer eingesetzt wird, das eine oder mehrere Innenlagen aus Kupfer mit Leiterbildern und Zwischenlagen aus Kunststoffolie aufweist und beidseitig mit einer Kupferschicht versehen ist, dadurch gekennzeichnet,
daß auf beiden Seiten des Multilayers Fensterbereiche aus der Kupferschicht entfernt werden, daß eine laserätzbare Kunststoffolie eingesetzt wird, daß die Kunststoffolien an den nicht mit der äußeren Kupferschicht bedeckten Fensterbereichen mittels Laserbearbeitung von beiden Seiten des Multilayers aus entfernt wird, wobei die Kupferschichten der beiden Seiten als Maske dienen.

3. Verfahren nach einem der Patentansprüche 1 oder 2, gekennzeichnet durch folgende Verfahrensschritte
a) auf einer Seite einer Kunststoffolie (1) wird die Kupferschicht (2) zur Herstellung von Kontaktnasen bereichsweise entfernt;
b) die Kunststoffolie (1) wird mittels Laserbearbeitung bereichsweise entfernt, wobei die strukturierte Kupferschicht (2) der einen Seite als Maske dient;
c) auf der freigelegten Kupferschicht (2), die sich auf der anderen Seite der Kunststoffolie (1) befindet, wird in der entstandenen Aussparung (5) der Kunststoffolie (1) eine Kontaktnase (6) galvanisch aufgebaut,
d) aus der strukturierten Kupferschicht (2) werden Fensterbereiche (4) entfernt,
e) die Kunststoffolie (1) wird mittels Laserbearbeitung entfernt, wobei die Kupferschicht (2) als Maske dient.

4. Verfahren nach Anspruch 3, dadurch gekennzeichnet, daß die Kontaktnasen (6) aus Kupfer und Gold galvanisch aufgebaut werden.

5. Verfahren nach einem der Ansprüche 1 bis 4, dadurch gekennzeichnet, daß die Kupferoberflächen nach Abschluß der Laserbearbeitung galvanisch mit Gold (7) beschichtet werden.

6. Verfahren nach einem der Ansprüche 1 bis 5, dadurch gekennzeichnet, daß die Laserbearbeitung mit einem Excimerlaser durchgeführt wird.
